Europäisches Patentamt

European Patent Office

Office européen des brevets

(11) Publication number: **0 117 335**
**A1**

# EUROPEAN PATENT APPLICATION

(21) Application number: **83306261.5**

(22) Date of filing: **14.10.83**

(51) Int. Cl.³: **H 01 L 31/02,** H 01 L 31/10, H 01 L 27/06

(30) Priority: **28.02.83 US 470664**

(43) Date of publication of application: **05.09.84** Bulletin 84/36

(84) Designated Contracting States: **DE FR GB**

(71) Applicant: **Hewlett-Packard Company, 3000 Hanover Street, Palo Alto California 94304 (US)**

(72) Inventor: **Wang, Shih-Yuan, 766 Encina Grande, Palo Alto California 94306 (US)**
Inventor: **Bloom, David M., 1180 Hermosa Bay, Menlo Park California 94025 (US)**

(74) Representative: **Oliver, Peter Anthony, Hewlett-Packard Limited Nine Mile Ride Easthampstead, Wokingham, Berkshire RG11 3LL (GB)**

(54) **High speed photodiodes.**

(57) A high speed planar photodiode having a bandwidth in excess of 50 GHz is fabricated on gallium arsenide and includes a Schottky diode having an optically transparent metal barrier (11) or a heterojunction diode having an optically transparent heterojunction region. The diode is surrounded by a nonconducting region (21) to minimise fringing fields and beam leads may be provided to minimise lead inductance. A high speed MESFET phototransistor using the planar photodiode is also disclosed.

EP 0 117 335 A1

1

# HIGH SPEED PHOTODIODES

This invention is concerned with photodiodes.

Photodiodes are useful for converting light into an electrical signal in, for example, a fiber optic communications system or a time domain reflectometer. Speed requirements in the past have typically been low enough that the frequency response of prior art vertical mesa structure photodiodes has been adequate. But, the parasitic capacitance and inductance inherent in a vertical mesa structure photodiode, which has an anode on one side of a chip and a cathode on the other side, render such prior art devices too slow for systems requiring gigahertz range speeds.

The present invention provides a planar photodiode comprising: a substrate; a conductive layer overlaying the substrate and characterized by an active layer over-laying a diode portion of the conductive layer; a substantially phototransparent barrier region overlaying the active layer; and an ohmic contact upon the conductive layer and substantially coplanar with the active layer.

The barrier region may comprise a Schottky barrier, e.g., composed of platinum. Alternatively the barrier region may comprise a hetero junction layer, e.g., of gallium aluminium arsenide.

In a photodiode as set forth in either one of the last two preceding paragraphs, it is preferred that an etched region is laterally interposed between the ohmic contact and the diode region.

In a photodiode as set forth in any one of the last three preceding paragraphs, it is preferred that beam leads are connected to the barrier region and to the ohmic contact.

The present invention further provides a planar phototransistor comprising; a substrate; a conductive layer overlaying the substrate; a planar field effect transistor having gate, source, and drain regions located upon the conductive layer; an active layer overlaying a diode portion of the conductive layer; a substantially phototransparent barrier region, over-laying the active layer; and, an ohmic contact upon the conductive layer and substantially coplanar with the active layer.

The gate may comprise the barrier region.

The barrier region may comprise a Schottky barrier, e.g., composed of platinum.

Alternatively the barrier region may comprise a heterojunction layer, e.g., of gallium aluminium arsenide.

In a phototransistor as set forth in any one of the last three immediately preceding paragraphs, it is preferred that an etched region is laterally interposed between the ohmic contact and the diode region.

In accordance with the preferred embodiment of the present invention, a high speed Schottky barrier photodiode is constructed which has a bandwidth in excess of 50 GHz. The photodiode is fabricated in a planar structure wherein both the anode and the cathode contacts are on the same surface and much of the parasitic capacitance inherent in a mesa structure is thereby eliminated. An active region is located on a semiinsulating substrate and an optically transparent Schottky barrier or heterojunction overlays the active region. The Schottky diode is mesa etched down to the conductive layer to increase bandwidth by decreasing fringing fields. Beam leads may be provided to the anode and cathode connections to decrease series inductance. An integrated gallium arsenide MESFET device is also disclosed which utilizes the high speed Schottky barrier photodiode as part of a high speed single chip phototransistor without the necessity of using bond wires between the MESFET and the photodiode.

There now follows a detailed description which is to be read with reference to the accompanying drawings of a photodiode and a phototransistor according to the present invention; it is to be clearly understood that the photodiode and the phototransistor have been selected for description to illustrate the invention by way of example and not by way of limitation.

In the accompanying drawings:--

Figure 1 is a view of a photodiode which is constructed according to the preferred embodiment of the present invention;

Figures 2 to 2E depict, in cross-section, the process steps performed in the fabrication of the photodiode shown in Figure 1;

Figure 3 depicts another embodiment of the present invention in which beam leads are provided on the photodiode shown in Figure 1,

Figure 4 is a view of a high speed integrated MESFET phototransistor which utilizes the photodiode shown in Figure 1; and

Figure 5 is a schematic diagram of the phototransistor shown in Figure 4.

4

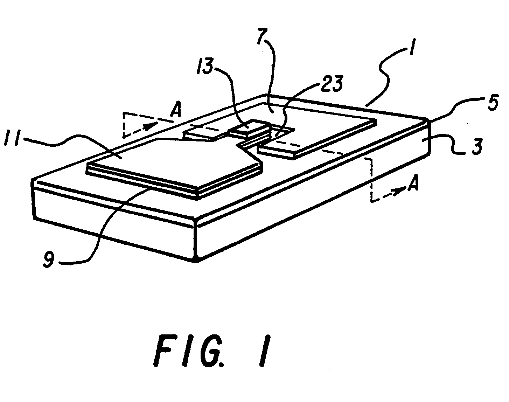

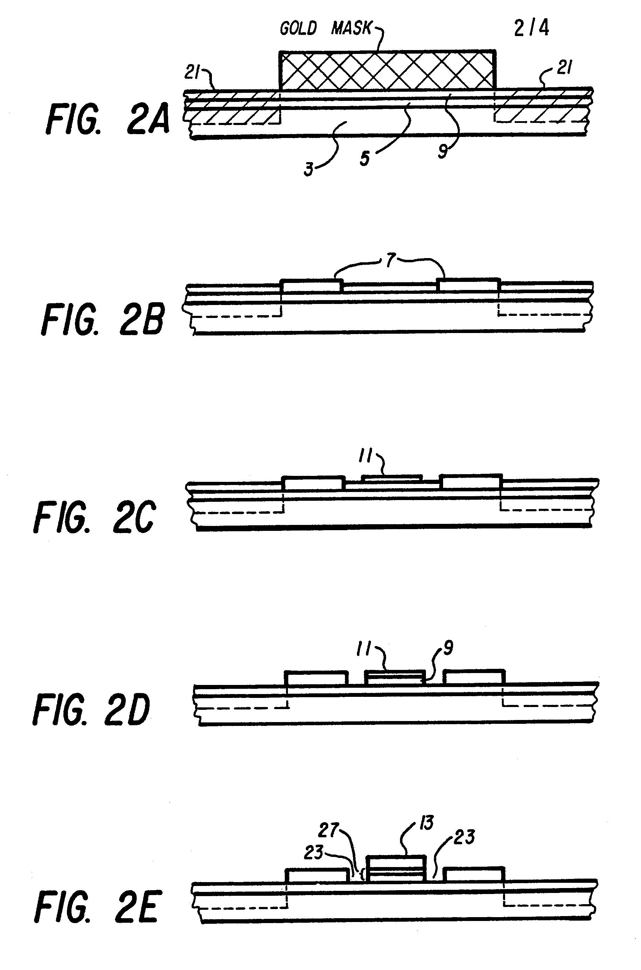

Figure 1 shows a photodiode 1 which is constructed in accordance with the preferred embodiment of the present invention. The photodiode 1 may be better understood with additional reference to Figures 2 A to 2E which depict the process steps performed during the fabrication of the photodiode 1. Figures 2A to 2E are cross-section views taken along the line A-A in Figure 1. A substrate 3 comprises a 3 to 5 mil thick layer of semiinsulating GaAs substrate having outside dimensions of 12 by 12 mil. Deposited thereupon is a 0.4 micron thick conductive layer 5 comprising $n^+$ GaAs having a doping concentration of at least $5 \times 10^{18}/cm^3$. Overlaying the conductive layer 5 is a 0.4 micron thick active layer 9 comprising $n^-$ GaAs having a doping concentration of no more than $5 \times 10^{15}/cm^3$.

In Figure 2A a proton bombardment step is shown in which the areas of the substrate 3 and the layers 5 and 9 not protected by a gold mask are proton damaged. The result of the proton bombardment is that the region 21 is rendered non-conductive and the only remaining active region is under the gold mask. In Figure 2B, the gold mask is removed, the active layer 9 is etched as required and an ohmic contact 7 is deposited on the conductive layer 5. In Figure 2C, a phototransparent barrier 11 is deposited on the active layer 9. The barrier 11 may comprise, e.g., 100 angstroms of platinum in order to form a Schottky barrier diode. Alternatively, the barrier 11 may comprise a heterojunction layer such as 4000 angstroms of gallium aluminium arsenide which is substantially transparent to a typical semiconductor laser wavelength of 845 nanometers when the concentration of aluminium is approximately 30%.

In Figure 2D, chemical etching and ion milling is used to remove the active layer 9 except as shown in Figure 1. Thus, the only remaining portion of the active layer 9 underlie the barrier 11. In Figure
2E, a dielectric 13 is deposited over a portion of the
barrier 11 to provide scratch protection and to minimise
light reflection. The junction of the active layer 9 and
the barrier 11 underlying the dielectric 13 comprises
a 5 micron by 5 micron diode 21 that is to be activated by
photons penetrating the dielectric 13. It should be noted
that a 2 micron wide mesa etched region 23 is provided
around diode 27 to increase bandwidth by decreasing
fringing fields. It should be noted that although the
dielectric 13 is shown to overlie only the diode 27, due
to processing limitations the dielectric 13 actually fills
the mesa etched region 23 and also overlies a portion of the
ohmic contact 7.

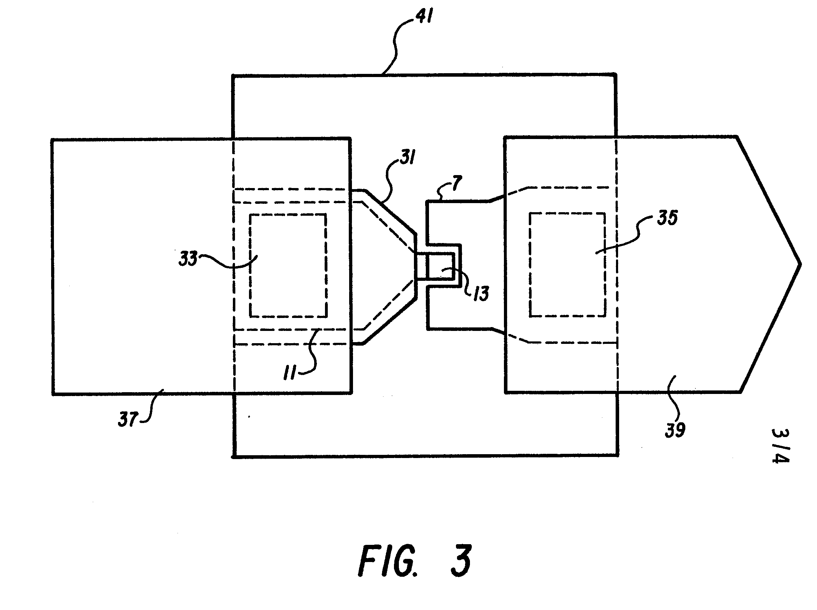

In Figure 3, a photodiode 41 is shown which is
fabricated as discussed above with reference to Figures 1
and 2 and which is further provided with beam leads 37 and
39 in order to minimise lead inductance. In order to
fabricate the photodiode 41, a photodiode 1 shown in
Figures 1 and 2 is fabricated. A metal layer 31 is
deposited on the barrier 11 in order to decrease series
resistance and gold pads 33 and 35 are deposited on the
metal layer 31 and the ohmic contact 7. The dielectric 13
and gold pads 33 and 35 are masked and the remainder of the
photodiode 41 is coated with a polyimide. The beam leads 37
and 39 are deposited and the photodiode 41 is etched to
a desired size and configuration. The beam lead 37
functions as an anode connection to the photodiode 41 and
the beam lead 39 functions as a cathode connection.

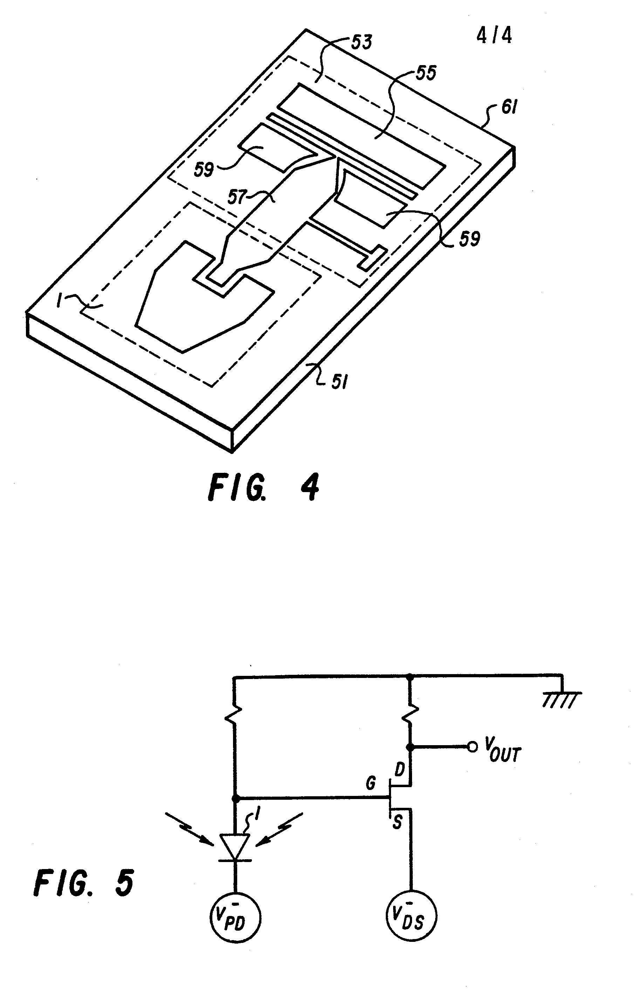

In Figure 5, a MESFET phototransistor 61 is
integrated upon a common GaAs substrate from a photodiode
1 and a MESFET 53. The MESFET 53 includes a drain 55, a
gate 57, and a source 59 and may be fabricated utilising
well known techniques such as those described in Liechti, Microwave Field-Effect Transistors--1976, Transactions On Microwave Theory And Techniques. Vol. MTT-24, No. 6, June 1976, at page 279, et seq. It is important to note that due to the low doping concentrations used in fabrication, the photodiode 1 may be operated at low bias levels, such as 1 volt which are compatible with transistor operations. Various matching networks may be utilised between the photodiode 1 and the MESFET 53 as required. In Figure 6, a circuit for operating the phototransistor 61 is shown.

CLAIMS

1.    A planar photodiode comprising:

a substrate (3);

a conductive layer (5) overlaying the substrate; and characterized by an active layer (9) overlaying a diode portion of the conductive layer;

a substantially phototransparent barrier region (11) overlaying the active layer; and,

an ohmic contact (7) upon the conductive layer and substantially coplanar with the active layer (9).

2.    A planar photodiode according to claim 1, characterized in that the barrier region (11) comprises a Schottky barrier.

3.    A planar photodiode according to claim 2, characterized in that the Schottky barrier is composed of platinum.

4.    A planar photodiode according to claim 1, characterized in that the barrier region comprises a heterojunction layer.

5.    A planar photodiode as in claim 4, characterized in that the heterojunction layer is composed of gallium aluminium arsenide.

6.    A planar photodiode according to any one of the preceding claims, characterized in that an etched region is laterally interposed between the ohmic contact and the diode region.

7.    A planar photodiode according to any one of the preceding claims, characterized in that beam leads are connected to the barrier region and to the ohmic contact.

8.    A planar phototransistor comprising:

a substrate (3);

a conductive layer (5) overlaying the substrate;

a planar field effect transistor having gate,

8

source, and drain regions located upon the conductive layer;

an active layer (9) overlaying a diode portion of the conductive layer;

a substantially phototransparent barrier region (11), overlaying the active layer; and,

an ohmic contact (7) upon the conductive layer and substantially coplanar with the active layer.

9.     A planar phototransistor according to claim 8, characterized in that the gate comprises the barrier region.

10.     A planar phototransistor according to either one of claims 8 and 9, characterized in that the barrier region comprises a Schottky barrier.

11.     A planar phototransistor according to claim 10, characterized in that the Schottky barrier is composed of platinum.

12.     A planar phototransistor according to either one of claims 8 and 9 characterized in that the barrier region comprises a heterojunction layer.

13.     A planar phototransistor according to claim 12, characterized in that the heterojunction layer is composed of gallium aluminium arsenide.

14.     A planar phototransistor according to any one of claims 8 to 13, characterized in that an etched region is laterally interposed between the ohmic contact and the diode region.

1/4

FIG. 1

FIG. 2A

FIG. 2B

FIG. 2C

FIG. 2D

FIG. 2E

FIG. 3

0117335

4/4

**FIG. 4**

**FIG. 5**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | GB - A - 2 028 583 (AEI SEMICON-DUCTORS) <br><br> * Page 1, lines 73-103; figures 1-3 * | 1-3 | H 01 L 31/02 <br> H 01 L 31/10 <br> H 01 L 27/06 |
| A | APPLIED PHYSICS LETTERS, vol. 39, no. 8, October 1981, New York, US W.C. BALLAMY et al.:"Low barrier height Schottky mixer diode using super thin silicon films by molecular beam epitaxy", pages 629-630 | 1,3-7 | |
| A | APPLIED PHYSICS LETTERS, Vol. 42, no. 2, January 1983, New York, US S.Y. WANG et al.: "20-GHz band-width GaAs photodiode", pages 190-192 | 1-7 | TECHNICAL FIELDS SEARCHED (Int. Cl. 3) <br><br> H 01 L 29/00 <br> H 01 L 31/00 |

The present search report has been drawn up for all claims

| Place of search | Date of completion of the search | Examiner |
|---|---|---|
| Berlin | 31-01-1984 | ROUSSEL |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03 82

European Patent
Office

0117335

## CLAIMS INCURRING FEES

The present European patent application comprised at the time of filing more than ten claims.

☐ All claims fees have been paid within the prescribed time limit. The present European search report has been drawn up for all claims.

☐ Only part of the claims fees have been paid within the prescribed time limit  The present European search report has been drawn up for the first ten claims and for those claims for which claims fees have been paid,

namely claims:

☐ No claims fees have been paid within the prescribed time limit. The present European search report has been drawn up for the first ten claims.

## ☒ LACK OF UNITY OF INVENTION

The Search Division considers that the present European patent application does not comply with the requirement of unity of invention and relates to several inventions or groups of inventions,
namely:

1) Claims 1-7: Photodiode
2) Claims 8-14: Phototransistor IC

☐ All further search fees have been paid within the fixed time limit. The present European search report has been drawn up fo all claims.

☐ Only part of the further search fees have been paid within the fixed time limit. The present European search report has been drawn up for those parts of the European patent application which relate to the inventions in respect of which search fees have been paid,

namely claims:

☒ None of the further search fees has been paid within the fixed time limit. The present European search report has been drawn up for those parts of the European patent application which relate to the invention first mentioned in the claims,

namely claims:      1-7